# EUROPÄISCHE PATENTSCHRIFT

(11) **EP 0 285 013 B1**
(45) Veröffentlichungstag und Bekanntmachung des Hinweises auf die Patenterteilung: **22.12.1993**
(21) Anmeldenummer: 88104799.7
(22) Anmeldetag: 25.03.1988
(51) Int. Cl.: G03F 7/004, G03F 7/022

(54) **Lichtempfindliches Gemisch und hieraus hergestelltes lichtempfindliches Kopiermaterial**
Light-sensitive composition and copying material prepared therewith
Composition photosensible et matériau pour copies préparé à partir de cette composition

(30) Priorität: 03.04.1987 DE 3711264
(43) Veröffentlichungstag der Anmeldung: 05.10.1988
(73) Patentinhaber: HOECHST AKTIENGESELLSCHAFT, 65926 Frankfurt am Main (DE)
(72) Erfinder: Stahlhofen, Paul, Dr. Dipl.-Chem., D-6200 Wiesbaden (DE)

(56) Entgegenhaltungen:
- EP-A- 0 133 216
- EP-A- 0 184 044

## Beschreibung

Die Erfindung betrifft ein lichtempfindliches Gemisch, das im wesentlichen ein wasserunlösliches, in wäßrig-alkalischen Lösungen lösliches Bindemittel, ein lichtempfindliches 1,2-Chinondiazid oder ein lichtempfindliches Gemisch aus einer bei Belichtung Säure abspaltenden Verbindung und einer Verbindung mit mindestens einer durch Säure spaltbaren C-O-C-Gruppe und eine thermisch vernetzende Verbindung enthält. Die Erfindung betrifft auch ein hieraus hergestelltes Kopiermaterial.

Lichtempfindliche Gemische, deren bildmäßig belichtete Bereiche in einer Entwicklerlösung löslich werden und deren unbelichtete Bereiche unlöslich sind, sind seit langem bekannt. Für die Herstellung derartiger Materialien werden in der Praxis vor allem Schichten mit o-Chinondiaziden als lichtempfindliche Verbindungen verwendet, die noch Harze mit alkalilöslich machenden Gruppen enthalten, z.B. Phenolharze.

Lichtempfindliche Gemische auf Basis säurespaltbarer Verbindungen sind ebenfalls bekannt. Sie enthalten als säurespaltbare Verbindungen Orthocarbonsäurederivate, monomere oder polymere Acetale, Enolether oder Acyliminocarbonate. Als strahlungsempfindliche, Säure abspaltende Verbindungen enthalten sie vorwiegend organische Halogenverbindungen, insbesondere durch Halogenmethylgruppen substituierte s-Triazine. Als Bindemittel werden auch Harze mit alkalilöslich machenden Gruppen verwendet.

Es ist auch bekannt, daß ein normalerweise positiv arbeitendes Kopiermaterial auf Basis von o-Chinondiaziden in Gegenwart geeigneter Zusatzstoffe durch eine bestimmte Folge von Behandlungen negativ verarbeitet werden kann. In der GB-A 2,082,339 ist ein derartiges Umkehrverfahren beschrieben, bei dem ein lichtempfindliches Gemisch, bestehend aus einem o-Chinondiazid und mindestens einem Resol, als negativ arbeitendes Aufzeichnungsmaterial benutzt werden kann. In der DE-OS 25 29 054 entsprechend US-PS 4,104,070 werden Resistschichten auf Basis von 1,2-Chinondiaziden für ein Umkehrverfahren beschrieben, die als Zusatzstoff Hydroxyalkylimidazoline enthalten. Ein ähnliches Material mit einem Gehalt an sekundären oder tertiären Aminen wird in der US-A 4,196,003 beschrieben. In EP-OS 0 133 216 entsprechend US-PS 4,581,321 wird ein Umkehrverfahren beschrieben, welches als Zusatz zur o-Chinondiazid-haltigen Kopierschicht einen Hexamethylolmelaminether enthält, der vorzugsweise als Vernetzungsmittel bei Polymerreaktionen Verwendung findet, während in EP-OS 0 131 238 entsprechend US-PS 4,576,901 ein Umkehrverfahren beschrieben wird, dessen lichtempfindliches Material keinen der oben erwähnten basischen oder sauren Zusätze erfordert.

Bekannt ist ferner ein Positiv-Negativ-Umkehrverfahren auf Basis säurespaltbarer Verbindungen anstelle von 1,2-Chinondiaziden, wie es in EP-OS 0 082 463 entsprechend US-PS 4,506,006 beschrieben ist.

Die genannten Umkehrverfahren enthalten im Prinzip die gleiche Folge von Verarbeitungsschritten, wobei nach der bildmäßigen Belichtung die Druckplatte erwärmt wird, nach dem Abkühlen nochmals ohne Vorlage nachbelichtet und dann mittels eines wäßrig-alkalischen Entwicklers entwickelt wird.

Die bekannten Umkehrverfahren beruhen darauf, daß die entstandenen Lichtzersetzungsprodukte beim Erwärmen ein unlösliches Reaktionsprodukt ergeben. Diese thermische Härtung (Vernetzung) erfolgt vorzugsweise in Gegenwart bestimmter basischer oder saurer Zusätze zur Kopierschicht oder in Gegenwart bestimmter Vernetzungsmittel mit multifunktionalen reaktionsfähigen Gruppen.

Derartige Zusätze haben jedoch im allgemeinen einen nachteiligen Einfluß auf die Lagerfähigkeit der Kopierschichten und auf bestimmte kopiertechnische Eigenschaften, wie z.B. die Lichtempfindlichkeit und den Bildkontrast nach dem Belichten. Auch ist für viele Anwendungszwecke die zur Bildumkehr erforderliche Temperatur zu hoch oder die Dauer des Erhitzens bei niedrigerer Temperatur zu lang oder der Temperaturbereich zur Umkehrbehandlung ist zu klein.

Das in EP-OS 0 133 216 beschriebene Umkehrverfahren enthält, wie eingangs erwähnt, als wesentlichen Bestandteil in der Kopierschicht neben einem 1,2-Chinondiazid einen Ether des Hexamethylolmelamin. Obwohl derartige Melaminether die Bildumkehr eines normalerweise positiv arbeitenden lichtempfindlichen Materials während der thermischen Härtung an den belichteten Bildbereichen in vorteilhafter Weise fördern, haben derartige Hexamethylolmelaminether jedoch den Nachteil, daß die Temperaturtoleranzen des Umkehrspielraums relativ gering sind, wodurch es zu unterschiedlichen Kopierergebnissen kommen kann. Ein weiterer großer Nachteil ist die mangelhafte Lagerfähigkeit der Druckplatten infolge der reaktionsfähigen Gruppen der Hexamethylolmelaminether, insbesondere bei erhöhten Temperaturen, was zu einer vorzeitigen Vernetzung führt, wodurch die Druckform unbrauchbar wird.

Aufgabe der Erfindung war es, ein lichtempfindliches Gemisch und ein hieraus hergestelltes Kopiermaterial zur Herstellung negativer Kopien mittels eines normalerweise positiv arbeitenden lichtempfindlichen Kopiermaterials auf Basis von zum Beispiel 1,2-Chinondiaziden vorzuschlagen, das die obengenannten Nachteile nicht aufweist, das insbesondere die gute Lagerfähigkeit der Druckplatten auch bei erhöhten Temperaturen nicht nachteilig beeinträchtigt und das ferner einen relativ großen Umkehrspielraum besitzt.

Die Erfindung geht aus von einem lichtempfindlichen Gemisch, das im wesentlichen ein wasserunlösliches, in wäßrig-alkalischen Lösungen lösliches Bindemittel, ein lichtempfindliches 1,2-Chinondiazid oder ein lichtempfindliches Gemisch aus einer bei Belichtung Säure abspaltenden Verbindung und einer Verbindung mit mindestens einer durch Säure spaltbaren C-O-C-Gruppe und eine thermisch vernetzende Verbindung enthält.

Das erfindungsgemäße Gemisch ist dadurch gekennzeichnet, daß als thermisch vernetzende Verbindung ein Harnstoff- bzw. Urethan-Formaldehydkondensationsprodukt vorhanden ist. Vorzugsweise handelt es sich um Kondensationsprodukte nach der allgemeinen Formel I 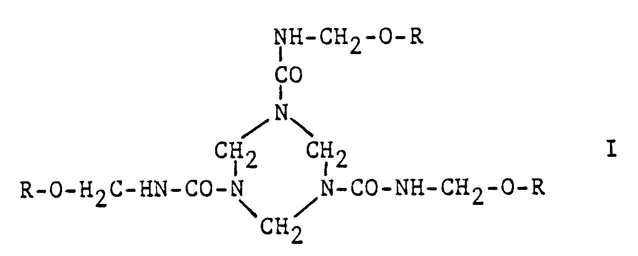
bzw. um Kondensationsprodukte nach der allgemeinen Formel II 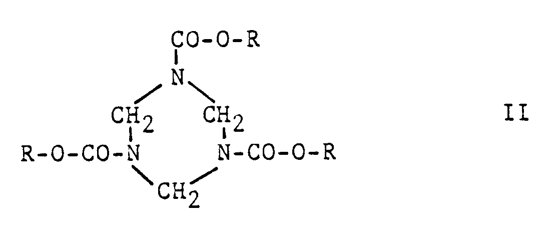
in denen R Wasserstoff oder eine Alkylgruppe darstellt.

Als besonders geeignet haben sich Verbindungen wie nicht plastifiziertes Harnstoff-Formaldehyd-Harz oder Butylurethan-Formaldehyd-Harz erwiesen.

Nach W. Lengsfeld (Farben und Lacke 75, 1969, S. 1063) besitzt dies beanspruchte Harnstoffharz überwiegend eine aus drei Harnstoff-Grundmolekülen aufgebaute cyclische Hexahydrotriazinstruktur entsprechend der allgemeinen Formel I.

Das gemäß der Erfindung einsetzbare Urethanharz (Carbamidsäureester-Harz), entspricht der Formel II, und liegt im wesentlichen ebenfalls als Hexahydrotriazinderivat vor.

Die Herstellung der veretherten Harnstoffharze erfolgt gewöhnlich in einem Zweistufenverfahren. Man kondensiert schwach alkalisch vor, stellt dann den Ansatz auf sauren pH-Wert um und kondensiert in Anwesenheit des betreffenden Alkohols zu Ende, wobei Wasser durch azeotrope Destillation laufend entfernt wird. Synthesebeispiele für beispielsweise mit Butanol oder Isobutanol veretherte Harnstorf-Formaldehyd-Harze sind in Houben-Weyl: " Methoden der organischen Chemie" 14/2, S. 350/351, Beispiel 10, 11 und 14 angegeben. Die Herstellung der Urethanharze erfolgt durch saure Kondensation von Carbamidsäureestern mit Formaldehyd. Ein Synthesebeispiel ist in Houben-Weyl: "Methoden der organischen Chemie" 14/2, S. 379, Beispiel 10 angegeben.

Das erfindungsgemäße lichtempfindliche Gemisch enthält das Kondensationsprodukt in einer Menge von 0,1 - 5,00 Gewichtsprozent, vorzugsweis 0,5 - 3 Gewichtsprozent, bezogen auf das Gewicht seiner nicht-flüchtigen Bestandteile.

Ein wesentlicher Vorteil gegenüber den bekannten Umkehrverfahren zur Herstellung negativer Kopien mittels eines normalerweise positiv arbeitenden lichtempfindlichen Materials auf Basis von zum Beispiel 1,2-Chinondiaziden ist, daß in Gegenwart der erfindungsgemäß verwendeten Formaldehyd-Kondensationsprodukte die Temperaturtoleranzen des eigentlichen Umkehrspielraums relativ groß sind, wodurch die Tonwiedergabe auch bei großen Temperaturschwankungen während des Umkehrschrittes nicht nachteilig beeinflußt wird.

Brauchbare Sensibilisatoren, die gemäß der Erfindung verwendet werden können, sind alle 1,2-Chinondiazidsulfonsäureester, besonders alle 1,2-Chinondiazidsulfonsäure-4-ester, 1,2-Chinondiazidsulfonsäure-4-amide, 1,2-Chinondiazidcarbonsäure-4-ester und -amide, die nach dem Bestrahlen mit aktinischem Licht in wäßrig-alkalischen Lösungen löslich werden.

Als Ester der 1 ,2-Chinondiazidderivate kommen die bekannten Umsetzungsprodukte der Säuren oder ihrer Halogenide mit Phenolen, in Betracht, z.B. mit 2,3,4-Trihydroxy-benzophenon, 2,4-Dihydroxy-benzophenon, 4-Decanoylresorcin, 4-(2-Phenylprop-2-yl)phenol, Gallussäureoctylester oder 4,4-Bis-(4-hydroxyphenyl)valeriansäurebutylester. Die Amide können in bekannter Weise von längerkettigen aliphatischen oder bevorzugt aromatischen Aminen abgeleitet sein.

Die Menge an o-Chinondiazidverbindungen beträgt im allgemeinen 3 bis 50, bevorzugt 7 bis 35 Gewichtsprozent, bezogen auf die nicht-flüchtigen Anteile des Gemisches.

Das lichtempfindliche Gemisch enthält ferner vorzugsweise ein polymeres, wasserunlösliches harzartiges Bindemittel, das sich in den für das erfindungsgemäße Gemisch verwendeten Lösungsmitteln löst und in wäßrigen Alkalien löslich oder zumindest quellbar ist.

Die bei vielen positiv-Kopiermaterialien auf Basis von Naphthochinondiaziden bewährten Novolak-Kondensationsharze haben sich als Bindemittel auch erfindungsgemäß als vorteilhaft erwiesen. Die Novolake können auch in bekannter Weise durch Umsetzung eines Teils ihrer Hydroxygruppen, z.B. mit Chloressigsäure, Isocyanaten, Epoxiden oder Carbonsäureanhydriden, modifiziert sein. Als weitere alkalilösliche bzw. in Alkali quellbare Bindemittel werden Polyhydroxyphenolharze, die durch Kondensation aus Phenolen und Aldehyden oder Ketonen hergestellt werden, Mischpolymerisate aus Styrol und Maleinsäureanhydrid, Polyvinylphenole oder Mischpolymerisate der Acrylsäure oder Methacrylsäure, insbesondere mit Acryl- oder Methacrylsäurephenolestern, bevorzugt. Die Art und Menge des alkalilöslichen Harzes kann je nach Anwendungszweck verschieden sein; bevorzugt werden Anteile am Gesamtfeststoff zwischen 90 und 30, insbesondere zwischen 85 - 55 Gewichtsprozent eingesetzt.

Zusätzlich können auch zahlreiche andere Harze mitverwendet werden, bevorzugt Epoxyharze und Vinylpolymerisate wie Polyvinylpyrrolidone und die Mischpolymerisate der ihnen zugrundeliegenden Monomeren sowie hydrierte oder teilhydrierte Kolophoniumderivate.

Der günstigste Anteil an diesen Harzen richtet sich nach den anwendungstechnischen Erfordernissen und dem Einfluß auf die Entwicklungsbedingungen und beträgt im allgemeinen nicht mehr als 50 bevorzugt etwa 2 bis 35 Gewichtsprozent, vom alkalilöslichen Harz. In geringen Mengen kann das lichtempfindliche Gemisch für spezielle Erfordernisse wie Flexibilität, Haftung, Glanz und Färbung, außerdem noch Substanzen wie Polyglykole, Cellulosederivate wie Ethylcellulose, Netzmittel, Farbstoffe, Haftvermittler und feinteilige Pigmente sowie bei Bedarf UV-Absorber enthalten.

Ferner können dem lichtempfindlichen Gemisch für den Farbumschlag nach dem Belichten noch geringe Mengen von strahlungsempfindlichen Komponenten beigefügt werden, die beim Belichten vorzugsweise starke Säuren bilden bzw. abspalten und in einer Folgereaktion mit einem geeigneten Farbstoff einen Farbumschlag hervorrufen. Derartige strahlungsempfindliche Komponenten sind zum Beispiel 1,2-Naphthochinondiazid-4-sulfonsäurechlorid, chromophor substituierte Bis- oder Trishalogenmethyl-s-triazine oder Diazoniumverbindungen in Form ihrer Salze mit komplexen Säuren wie Borfluorwasserstoffsäure oder Hexafluorphosphorsäure.

Gegenstand der Erfindung ist auch ein lichtempfindliches Kopiermaterial, bestehend aus einem Schichtträger und einer lichtempfindlichen Schicht, die im wesentlichen ein wasserunlösliches, in wäßrig-alkalischen Lösungsmitteln lösliches Bindemittel, ein lichtempfindliches 1 ,2-Chinondiazid oder ein lichtempfindliches Gemisch aus einer bei Belichtung Säure abspaltenden Verbindung und einer Verbindung mit mindestens einer durch Säure spaltbaren C-O-C -Gruppe und eine thermisch vernetzende Verbindung enthält. Das Kopiermaterial ist dadurch gekennzeichnet, daß es als thermisch vernetzende Verbindung ein Harnstoff- bzw. Urethan-Formaldehydkondensationsprodukt enthält.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Ethylen- oder Propylenglykolmonoalkylether und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren. Partialether von Glykolen, insbesondere Ethylenglykolmonomethylether und Propylenglykolmethylether werden besonders bevorzugt.

Als Schichtträger für Schichtdicken unter etwa 10 µm werden meist Metalle verwendet. Für Offsetdruckplatten können eingesetzt werden: Walzblankes, mechanisch oder elektrochemisch aufgerauhtes und gegebenenfalls anodisiertes Aluminium, das zudem noch chemisch, z.B. mit Polyvinylphosphonsäure, Silikaten, Phosphaten, Hexafluorozirkonaten oder mit hydrolisiertem Tetraethylorthosilikat, vorbehandelt sein kann.

Die Beschichtung des Schichtträgers erfolgt in bekannter Weise durch Aufschleudern, Sprühen, Tauchen, Walzen mittels Breitschlitzdüsen, Rakeln oder durch Gießer-Antrag.

Zum Entwickeln werden wäßrig-alkalische Lösungen abgestufter Alkalität verwendet, vorzugsweise mit einem pH im Bereich von 10 - 14, die auch kleinere Mengen organischer Lösungs- oder Netzmittel enthalten können.

Zur Umkehrbehandlung wird das Kopiermaterial nach dem bildmäßigen Bestrahlen bzw. Belichten ohne weitere Zwischenbehandlung erwärmt. Das Erwärmen kann durch Bestrahlung, Konvektion, durch Kontakt mit erwärmten Flächen, z.B. durch Walzen, oder durch Tauchen in ein erwärmtes Bad einer inerten Flüssigkeit, z.B. Wasser, erfolgen. Die Temperatur kann zwischen 80 und 150, vorzugsweise bei 100 bis 130 °C liegen. Derartige Temperaturen werden von den Gemischen vertragen, ohne daß die Eigenschaften der unbelichteten, zum Beispiel abgedeckten Bereiche wesentlich verändert werden. Die Dauer des Erwärmens kann je nach Art der Wärmeeinwirkung sehr unterschiedlich sein. Bei Übertragung durch ein Wärmemedium liegt sie zwischen 10 Sekunden und 10 Minuten, besonders zwischen 1 und 3 Minuten.

Nach dem Erwärmen und Abkühlen wird die Druckplatte einer Totalbelichtung unterworfen, um die noch lichtempfindlichen Schichtbereiche vollständig in ihre Lichtzersetzungsprodukte umzuwandeln. Die Nachbelichtung kann vorteilhaft unter der gleichen Lichtquelle erfolgen, die zur Bildbelichtung verwendet wurde.

An die Nachbelichtung schließt sich eine Entwicklung mit üblichen Entwicklern an, wobei die Schichtbereiche ausgewaschen werden, die bei der ursprünglichen Bildbelichtung nicht vom Licht getroffen waren. Als Entwickler sind vorzugsweise wäßrige Lösungen von alkalischen Substanzen abgestufter Alkalität, zum Beispiel von Alkaliphosphaten, -silikaten, -carbonaten oder -hydroxiden geeignet, die ferner Netzmittel oder kleinere Mengen organischer Lösungsmittel enthalten können. In bestimmten Fällen sind auch organische Lösungsmittel oder Gemische derselben mit Wasser als Entwickler geeignet. Die Entwicklung kann unmittelbar nach dem Erwärmen und Abkühlen oder auch in zeitlichem Abstand von zum Beispiel mehreren Stunden erfolgen, ohne daß die gehärteten Schichtbereiche angegriffen werden.

Mit den erfindungsgemaß beanspruchten Kopierschichten lassen sich außer der Herstellung einer Negativ-Kopie von der normalerweise positiv arbeitenden Kopierschicht auch vorteilhaft verschiedene Kombinationsmöglichkeiten beim Zusammenkopieren von Strich-und Rasterfilmen verwirklichen (Photocomposing). So kann man beispielsweise unmittelbar nach der ersten bildmäßigen Belichtung unter einer Negativ-Vorlage nachträglich in den noch nicht vom Licht getroffenen Schichtbereichen, die während der ersten Belichtung durch eine Maske abgedeckt waren, mit Hilfe einer Positiv-Vorlage zusätzlich noch ein weiteres Strich-oder Rasterbild einkopieren. Die so belichtete Druckplatte wird anschließend ohne weitere Zwischenschritte entwickelt. Man erhält eine fertige Druckform, auf der, je nach Abdeckung, noch weitere Informationen positiv oder negativ aufgebracht werden könnten.

Die erfindungsgemäßen Kopierschichten bringen den Vorteil mit sich, daß bei guter Lagerfähigkeit der Kopierschichten, auch bei erhöhten Temperaturen, die Aushärtung der bildmäßig belichteten Schichtbereiche in der Wärme relativ schnell erfolgt.

Vorteilhaft ist vor allem, daß in Gegenwart der erfindungsgemäßen verwendeten Formaldehyd-Kondensationsprodukte in der Kopierschicht die Temperaturtoleranzen des Umkehrspielraums relativ groß sind, wodurch die Tonwertwiedergabe auch bei großen Temperaturschwankungen während des Umkehrschrittes nicht nachteilig beeinflußt wird.

Zusätzliche Behandlungsschritte mit Flüssigkeiten oder eine besondere Zusammensetzung des lichtempfindlichen Materials sind nicht erforderlich. Der einzige zusätzliche Behandlungsschritt, das Erwärmen, kann zumeist mit vorhandenen Trocknungsgeräten bequem durchgeführt werden. Die letzte Belichtung ohne Vorlage wird am einfachsten wieder mit der Kopierlichtquelle durchgeführt.

Das erfindungsgemäße Material kann zum Beispiel zur Herstellung von Druckformen für den Hoch-, Tief- und Flachdruck sowie von Photoresistschablonen für die subtraktive und additive Leiternplattenherstellung, für die galvanische Herstellung von Nickelrotationszylindern oder für die Maskenherstellung in der Mikroelektronik nach der Lift-off-Technik eingesetzt werden.

Die folgenden Beispiele beschreiben bevorzugte Ausführungsformen. Prozentzahlen und Mengenverhältnisse sind, wenn nichts anderes angegeben ist, in Gewichtseinheiten zu verstehen.

### Beispiel 1:

Mit einer Lösung von
1,400 Gt des Veresterungsproduktes aus 1 Mol 4-(2-Phenyl-prop-2-yl)-phenol und 1 Mol Naphthochinon-(1,2)-diazid-(2)-4-sulfonsäurechlorid,
7,600 Gt eines Kresol-Formaldehyd-Novolaks mit einem Erweichungspunkt von 127 - 145 °C,
0,100 Gt eines nicht plastifizierten Formaldehyd-Harnstoff-Harzes (Resamin HF 227 der Hoechst AG)
0,080 Gt 2,4-Bis-trichlormethyl-6-p-stilbenyl-s-triazin
0,080 Gt Kristallviolett, Color Index (C.I.) 42 555,
55,00 Gt Ethylenglykolmonomethylether und
70,00 Gt Tetrahydrofuran
wurde eine elektrochemisch aufgerauhte und anodisierte Aluminiumplatte beschichtet. Der anodisierte Aluminiumträger war vor dem Aufbringen der lichtempfindlichen Kopierschicht mit einer wäßrigen Lösung von 0,1 Gewichtsprozent Polyvinylphosphonsäure behandelt worden.

Das so hergestellte vorsensibilisierte Material mit einem Schichtgewicht von ca. 2,3 g/m² wurde unter einer transparenten Positiv-Vorlage mit Hilfe einer Metall-Halogenid-Lampe von 500 Watt bei einem Lampenabstand von 103 cm mit 60 Takten bildmäßig belichtet und anschließend mit der 5 %igen wäßrigen Lösung von Natriumsilikat entwickelt. Durch die Entwicklung wurden die vom Licht getroffenen Anteile der Kopierschicht entfernt, und es blieben die unbelichteten Bildstellen auf dem Schichtträger zurück, wodurch man die der Vorlage entsprechende Druckschablone erhielt. Durch Einfärben mit Fettfarbe wurde eine druckfertige Positiv-Druckform erhalten.

Eine andere Probe des gleichen vorsensibilisierten Materials wurde als Negativ-Druckplatte verarbeitet. Zu diesem Zweck wurde die Probe unter einer negativen Vorlage 60 Takte lang belichtet, anschließend 2 Minuten auf 120 °C erwärmt und dann ohne Vorlage 30 Takte nachbelichtet. Durch Entwickeln im gleichen Entwickler innerhalb der gleichen Zeit entstand das Umkehrbild der Vorlage.

Eine andere Möglichkeit der Verarbeitung ist das nachträgliche Einkopieren von Strich- oder Rastervorlagen auf eine bereits bildmäßig belichtete Druckplatte nach dem Photocomposing-Verfahren. Zu diesem Zweck wird das hergestellte vorsensibilisierte Material zunächst unter einer Negativ-Vorlage, bildmäßig belichtet, anschließend 2 Minuten auf 120 °C erwärmt, dann an den noch nicht vom Licht getroffenen Schichtbereichen unter einem Diapositiv nochmals belichtet. Die so mehrmals belichtete Druckplatte wird ohne weitere Zwischenschritte entwickelt wodurch man die fertige Druckform erhält.

Ein großer Vorteil gegenüber den bisher bekannten Umkehrplatten und Verfahren ist der relativ große Behandlungsspielraum während des Temperungsschrittes. Dies wird deutlich, wenn die hergestellte normalerweise positiv arbeitende lichtempfindliche Druckplatte unter einer Negativ-Vorlage in Gegenwart eines in der Offsetkopie üblichen Testkeils, beispielsweise des UGRA-Offset-Testkeils 1982, bildmäßig belichtet und anschließend der zur Bildumkehr notwendige Erwärmungsschritt durchgeführt wird. Wird das Tempern der bildmäßig belichteten Druckplatte beispielsweise während 2 Minuten durchgeführt, so kann die Temperatur zwischen 115 und 140 °C variiert werden, ohne daß an dem resultierenden Testbild nach der anschließenden vollflächigen Nachbelichtung und Entwicklung eine Veränderung sichtbar wird. Dies betrifft insbesondere die Wiedergabe des Halbtonstufenkeils, der sehr empfindlich auf jede chemische oder physikalische Änderung der Kopierschicht reagiert. Diese große Temperaturtoleranz des eigentlichen Umkehrschrittes während der Verarbeitung kommt der Praxis sehr entgegen, da die kopiertechnischen Eigenschaften, wie beispielsweise die Tonwiedergabe, auch bei relativ großen Temperaturschwankungen, wie sie bei den in der Praxis üblichen Wärmeöfen oder automatischen Conversionsgeräten durchaus vorkommen können, nicht nachteilig beeinflußt werden.

Wird das erfindungsgemäß eingesetzte methylveretherte Formaldehyd-Kondensationsprodukt beispielsweise durch die gleiche Menge Hexamethylolmelaminhexamethylether gemäß EP-A- 0 133 216 ersetzt und nach dem bildmäßigen Belichten unter derselben Testvorlage ebenfalls während zwei Minuten der Temperungsschritt durchgeführt, so resultiert lediglich ein Temperaturspielraum von etwa 15 °C.

In den folgenden Beispielen werden weitere Beschichtungslösungen angegeben, wobei ähnliche Ergebnisse erhalten werden, wie in Beispiel 1 angegeben. Wenn nicht gesondert vermerkt, entsprechen Herstellung und Verarbeitung der damit erhaltenen Druckplatten den in Beispiel 1 beschriebenen Bedingungen. Die Entwicklung der belichteteten Druckplatten erfolgt jeweils mit einer 5 %igen wässrigen Natriummetasilikatlösung.

### Beispiel 2

Die Beschichtungslösung besteht aus:
1,400 Gt des Veresterungsproduktes aus 1 Mol 2,3,4-Trihydroxybenzophenon und 3 Mol Naphthochinon(1,2)-diazid-(2)-4-sulfonsäure- chlorid,
7,600 Gt des in Beispiel 1 angegebenen Novolaks,
0,14 Gt eines Carbamidsäureesterharzes aus Butylurethan und Formaldehyd (Uresin B, HOECHST AG),
0,080 Gt 2,4-Bis-trichlormethyl-6-p-methoxystyryl-s-triazin,
0,080 Gt Kristallviolett
55,00 Gt Ethylenglykolmonomethylether und
70,00 Gt Tetrahydrofuran

### Beispiel 3:

Die Beschichtungslösung besteht aus:
1,400 Gt des Veresterungsproduktes aus 1 Mol 4-(2-Phenyl-prop-2-yl)-phenol und 1 Mol Naphthochinon-(1,2)-diazid-(2)-4-sulfonsäurechlorid,
7,600 Gt des in Beispiel 1 angegebenen Novolaks,
0,200 Gt eines nicht plastifizierten Formaldehyd-Harnstoff-Harzes (Resamin HF 180 der Hoechst AG)
0,080 Gt 2,4-Bis-trichlormethyl-6-p-stilbenyl-s-triazin
0,080 Gt Kristallviolett
55,00 Gt Ethylenglykolmonomethylether und
70,00 Gt Tetrahydrofuran

### Beispiel 4

Mit einer Lösung von
1,400 Gt eines Polyorthoesters, hergestellt aus 7,7-Bishydroxymethyl-5-oxa-nonanol-(1) und Orthoameisepsäuretrimethylester,
0,220 Gt 2,4-Bis-trichlormethyl-6-p-stilbenyl-s-triazin,
0,180 Gt eines Harzes nach Beispiel 1,
4,700 Gt des in Beispiel 1 angegebenen Novolaks,
0,040 Gt Kristallviolett-Base in
35,00 Gt Ethylenglykolmonomethylether und
45,00 Gt Tetrahydrofuran
wurde eine elektrolytisch aufgerauhte und anodisierte Aluminiumplatte beschichtet.

Das so hergestellte vorsensibilisierte Kopiermaterial mit einem Schichtgewicht von ca. 2,0 g/m² wurde unter einer transparenten Positiv-Vorlage mit Hilfe einer Metall-Halogenid-Lampe von 500 Watt bei einem Lampenabstand von 103 cm mit 10 Takten bildmäßig belichtet und anschließend mit einer 4 %igen wäßrigen Lösung von Natriumsilikat entwickelt. Durch die Entwicklung wurden die vom Licht getroffenen Anteile der Kopierschicht entfernt, und es blieben die unbelichteten Bildstellen auf dem Schichtträger zurück, wodurch man die der Vorlage entsprechende Druckschablone erhielt. Durch Einfärben mit Fettfarbe wurde eine druckfertige Positiv-Druckform erhalten.

Eine andere Probe des gleichen vorsensibilisierten Materials wurde als Negativ-Druckplatte verarbeitet. Zu diesem Zweck wurde die Probe unter einer negativen Vorlage 10 Takte lang belichtet, anschließend 2 Minuten auf 130 °C erwärmt und dann ohne Vorlage 10 Takte nachbelichtet. Durch Entwickeln im gleichen Entwickler innerhalb der gleichen Zeit entstand das Umkehrbild der Vorlage.

## Patentansprüche

1. Lichtempfindliches Gemisch, das im wesentlichen ein wasserunlösliches, in wäßrig-alkalischen Lösungen lösliches Bindemittel, ein lichtempfindliches 1,2-Chinondiazid oder ein lichtempfindliches Gemisch aus einer bei Belichtung Säure abspaltenden Verbindung und einer Verbindung mit mindestens einer durch Säure spaltbaren C-O-C -Gruppe und eine thermisch vernetzende Verbindung enthält, dadurch gekennzeichnet, daß als thermisch vernetzende Verbindung ein Harnstoff- bzw. Urethan-Formaldehydkondensationsprodukt vorhanden ist.

2. Gemisch nach Anspruch 1, dadurch gekennzeichnet, daß es als thermisch vernetzende Verbindung ein Kondensationsprodukt nach der allgemeinen Formel I 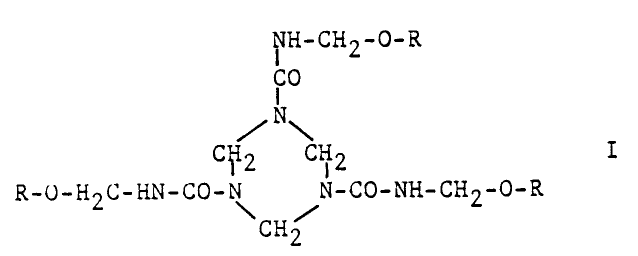 in welcher R Wasserstoff oder eine Alkylgruppe darstellt, enthält.

3. Gemisch nach Anspruch 1, dadurch gekennzeichnet, daß es als thermisch vernetzende Verbindung ein Kondensationsprodukt nach der allgemeinen Formel II 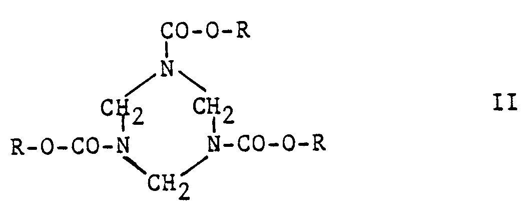 in welcher R Wasserstoff oder eine Alkylgruppe darstellt, enthält.

4. Gemisch nach Ansprüchen 1 und 2, dadurch gekennzeichnet, daß es als thermisch vernetzende Verbindung ein nicht plastifiziertes Harnstoff-Formaldehyd-Harz enthält.

5. Gemisch nach Ansprüchen 1 oder 3, dadurch gekennzeichnet, daß es als thermisch vernetzende Verbindung ein Butylurethan-Formaldehyd-Harz enthält.

6. Gemisch nach Ansprüchen 1 bis 5, dadurch gekennzeichnet, daß es die thermisch vernetzende Verbindung in einer Menge von 0,1 bis 5 Gewichtsprozent, bezogen auf seine nicht-flüchtigen Bestandteile, enthält.

7. Lichtempfindliches Kopiermaterial, bestehend aus einem Schichtträger und einer lichtempfindlichen Schicht, die im wesentlichen ein wasserunlösliches, in wäßrig-alkalischen Lösungen lösliches Bindemittel, ein lichtempfindliches 1,2-Chinondiazid oder ein lichtempfindliches Gemisch aus einer bei Belichtung Säure abspaltenden Verbindung und einer Verbindung mit mindestens einer durch Säure spaltbaren C-O-C -Gruppe und eine thermisch vernetzende Verbindung enthält, dadurch gekennzeichnet, daß als thermisch vernetzende Verbindung ein Harnstoff- bzw. Urethan-Formaldehydkondensationsprodukt vorhanden ist.

## Claims

1. A photosensitive composition which essentially comprises a binder which is insoluble in water and soluble in aqueous-alkaline solutions, a photosensitive 1,2-quinonediazide or a photosensitive mixture of a compound which splits off acid upon exposure to light and a compound containing at least one acid-cleavable C-O-C group, and a thermally crosslinking compound, characterized in that the thermally crosslinking compound used is a urea or urethane-formaldehyde condensation product.

2. A composition as claimed in claim 1, characterized in that it contains, as the thermally crosslinking compound, a condensation product according to the general formula I 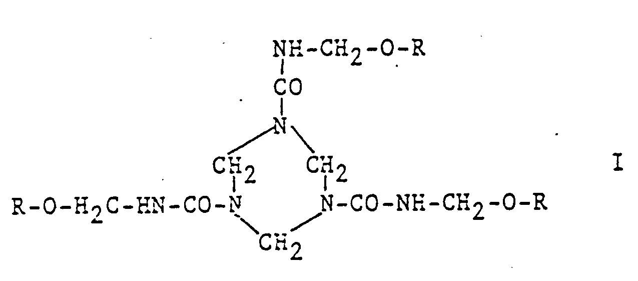 wherein R represents hydrogen or an alkyl group.

3. A composition as claimed in claim 1, characterized in that it contains, as the thermally crosslinking compound, a condensation product according to the general formula II 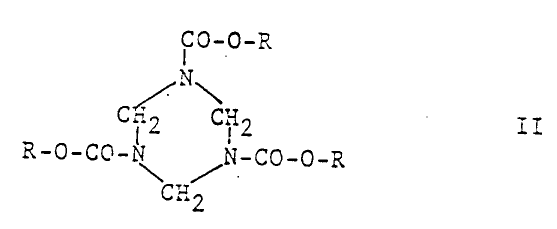 wherein R represents hydrogen or an alkyl group.

4. A composition as claimed in claims 1 and 2, characterized in that it contains, as the thermally crosslinking compound, a non-plastified urea-formaldehyde resin.

5. A composition as claimed in claim 1 or 3, characterized in that it contains, as the thermally crosslinking compound, a butylurethane-formaldehyde resin.

6. A composition as claimed in claims 1 to 5, characterized in that it contains the thermally crosslinking compound in a quantity from 0.1 to 5 percent by weight, based on its non-volatile constituents.

7. A photosensitive copying material comprising a layer support and a photosensitive layer which essentially comprises a binder which is insoluble in water and soluble in aqueous-alkaline solutions, a photosensitive 1,2-quinonediazide or a photosensitive mixture of a compound which splits off acid upon exposure to light and a compound containing at least one acid-cleavable C-O-C group, and a thermally crosslinking compound, characterized in that the thermally crosslinking compound used is a urea or urethane-formaldehyde condensation product.

## Revendications

1. Composition photosensible contenant essentiellement un liant insoluble dans l'eau, soluble dans des solutions aqueuses-alcalines, un 1,2-quinonediazide photosensible ou un mélange photosensible d'un composé libérant un acide lors de l'insolation et d'un composé comportant au moins un groupe C-O-C dissociable par un acide, et un composé réticulant à la chaleur, caractérisée en ce que le composé réticulant à la chaleur est un produit de condensation d'urée ou d'uréthanne et de formaldéhyde.

2. Composition selon la revendication 1, caractérisée en ce qu'elle contient, en tant que composé réticulant à la chaleur, un produit de condensation de formule générale I 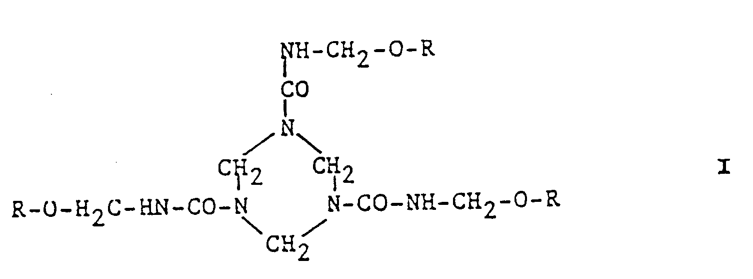 dans laquelle R représente un atome d'hydrogène ou un groupe alkyle.

3. Composition selon la revendication 1, caractérisée en ce qu'elle contient, en tant que composé réticulant à la chaleur, un produit de condensation de formule générale II 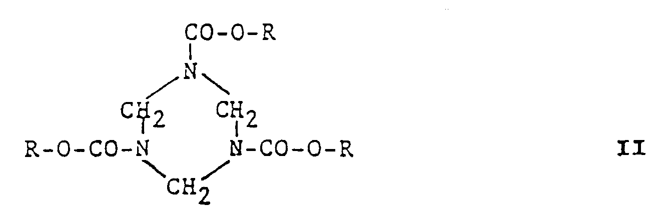 dans laquelle R représente un atome d'hydrogène ou un groupe alkyle.

4. Composition selon les revendications 1 et 2. caractérisée en ce qu'elle contient, en tant que composé réticulant à la chaleur, une résine urée-formaldéhyde non plastifiée.

5. Composition selon la revendication 1 ou 3, caractérisée en ce qu'elle contient; en tant que composé réticulant à la chaleur, une résine butyluréthanne-formaldéhyde.

6. Composition selon les'revendications 1 à 5, caractérisée en ce qu'elle contient le composé réticulant à la chaleur en une proportion de 0,1 à 5 % en poids, par rapport à ses composants non volatils.

7. Matériau de copie photosensible, composé d'un support de couche et d'une couche photosensible qui contient essentiellement un liant insoluble dans l'eau, soluble dans des solutions aquernses-alcalines, un 1,2-quinonediazide photosensible ou un mélange photosensible d'un composé libérant un acide lors de l'insolation et d'un composé comportant au moins un groupe C-O-C dissociable par un acide, et un composé réticulant à la chaleur, caractérisé en ce que, comme composé réticulant à la chaleur, est présent un produit de condensation d'urée ou d'uréthanne et de formaldèhyde.
